# EUROPÄISCHE PATENTSCHRIFT

(11) **EP 1 066 679 B1**
(45) Veröffentlichungstag und Bekanntmachung des Hinweises auf die Patenterteilung: **02.04.2008**
(21) Anmeldenummer: 00908977.2
(22) Anmeldetag: 01.02.2000
(51) Int. Cl.: H03F 1/30

(54) **VERFAHREN UND SCHALTUNG ZUR KOMPENSATIONSSTEUERUNG VON OFFSETSPANNUNGEN EINER IN EINEM SCHALTUNGSBAUSTEIN INTEGRIERTEN FUNKEMPFANGSSCHALTUNG**
METHOD AND CIRCUIT FOR CONTROLLING THE COMPENSATION OF OFFSET VOLTAGES OF A RADIO RECEIVER CIRCUIT WHICH IS INTEGRATED IN A CIRCUIT MODULE
PROCEDE ET CIRCUIT POUR COMMANDER LA COMPENSATION DE TENSIONS DE DECALAGE D'UN CIRCUIT DE RECEPTION RADIO INTEGRE DANS UN MODULE DE CIRCUIT

(30) Priorität: 03.02.1999 DE 19904377
(43) Veröffentlichungstag der Anmeldung: 10.01.2001
(73) Patentinhaber: Infineon Technologies AG, 81669 München (DE)
(72) Erfinder: SCHMAL, Josef, D-81547 München (DE); BEYER, Stefan, D-86415 Mering (DE)
(74) Vertreter: Reinhard - Skuhra - Weise & Partner
(86) Internationale Anmeldenummer: PCT/DE2000/000294
(87) Internationale Veröffentlichungsnummer: WO 2000/046918

(56) Entgegenhaltungen:
- EP-A- 0 561 754
- US-A- 5 270 883
- US-A- 5 699 343

## Beschreibung

Die Erfindung bezieht sich auf ein Verfahren gemäß dem Oberbegriff des Patentanspruchs 1.

Die Erfindung betrifft auch eine Schaltung zur Durchführung des Verfahrens.

Bei einem integrierten Funkempfänger- oder Funktransceiver-Schaltungsbaustein wird im Empfangspfad ein an der Antenne in der Hochfrequenzlage anliegendes Empfangssignal (Nutzsignal) zuerst in eine Zwischenfrequenzlage (ZF) und anschließend mittels eines Demodulators (Mischer) in die Basisbandlage (BB) umgesetzt.

In diesem Empfangspfad können nun fertigungsbedingt Offsetspannungen auftreten. Diese Offsetspannungen werden durch die im Empfangspfad liegenden Verstärker ebenso wie das Nutzsignal verstärkt. Liegt am Eingang eines 16 dB-Verstärkers z.B. eine Offsetspannung von 20 mV, so ergibt sich am Ausgang dieses Verstärkers eine Offsetspannung von 126 mV. Diese hohe Offsetspannung führt zu einer Begrenzung des Nutzsignals, da durch die Offsetspannung der Aussteuerbereich dieses Verstärkers und aller im Empfangspfad nachfolgenden Verstärker verringert wird.

In allen hochfrequenten Schaltungsteilen (HF- und ZF-Lage) kann die Offsetspannung an geeigneten Stellen durch eine kapazitive Kopplung eliminiert werden. In der Basisbandlage, in der die Signalfrequenzen bei etwa 100 kHz liegen, ist eine kapazitive Kopplung allerdings nicht mehr möglich, da im integrierten Schaltungsbaustein fur die kapazitive Kopplung sehr große Kapazitaten verwendet werden mußten. Derart große Kapazitäten benötigen jedoch beim Einschalten des Schaltungsbausteins sehr lange Aufladezeiten und beanspruchen eine erhebliche Chipfläche oder sind auf einem integrierten Schaltungsbaustein überhaupt nicht realisierbar.

Es ist aus der europäischen Patentanmeldung EP 0 693 823 bekannt, die im Basisband vorhandenen Offsetspannungen mit Hilfe einer Abtast- und Halteschaltung (Sample and Hold) zu kompensieren. Weiters zeigt auch EP 0561 754 eine Schaltung um die Offsetspannung zu eliminieren

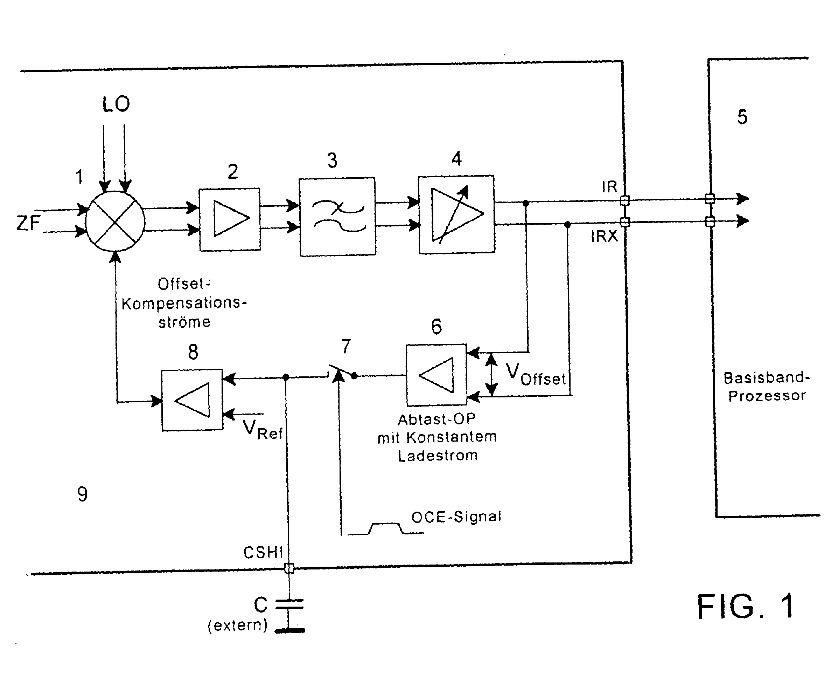

Wie eine in FIG. 1 abgebildete Prinzipdarstellung für eine solchen Kompensation im einzelnen zeigt, wird dazu das differentielle Basisbandsignal, das über einen mit einer Lokaloszillatorfrequenz LO betriebenen Demodulator 1 aus dem ZF-Signal ZF gewonnen und nach einem Pufferverstärker 2 mittels eines Tiefpaßfilters 3 gefiltert wird, intern im Anschluß an einen Basisband-Regelverstärker 4 am Basisbandausgang IR, IRX, der mit einem nachfolgenden Basisband-Prozessor 5 verbunden ist, abgegriffen und einem Abtast(Sample)-Operationsverstärker 6 zugeführt.

Dieser Abtast-Operationsverstärker 6 lädt bzw. entlädt über einen gesteuerten Abtastschalter 7 der Abtast- und Halteschaltung je nach Polarität der Offsetspannung V_{Offset} über einen Ausgang CSHI einen extern angebrachten Kondensator C. Die Kondensatorspannung wird einem Differenzverstärker 8 zugeführt und dort mit einer Referenzspannung V_{Ref} verglichen.

Am Ausgang des Differenzverstärkers 8 werden Kompensationsströme erzeugt, die der Offsetspannung V_{Offset} entgegenwirken. Der Offset-Kompensationsvorgang wird vor jedem Empfangszeitschlitz des im Zeitmultiplex (TDMA) betriebenen Funkempfangers durchgeführt. Dazu erfolgt die Steuerung des Abtastschalters 7 bei der bekannten Schaltung über ein sogenanntes OCE(Offset Compensation Enable)-Steuersignal OCE. Bei bekannten Schaltungen wird beim extern im Basisband-Prozessor 5 erzeugten, impulsförmigen Steuersignal OCE zur Steuerung des Kompensationsvorganges die Impulsbreite bei großen Offsetspannungen ebenfalls vergrößert.

Die diesbezüglichen Zusammenhänge werden nachfolgend im einzelnen erläutert. Eine derartige Kompensation der Offsetspannung V_{offset} im Basisband unter Verwendung einer Abtast-und Halteschaltung entsprechend FIG. 1 läßt sich in einem mit 9 bezeichneten integrierten Receiver-Schaltungsbaustein z.B. für tragbare GSM-Mobilfunkgeräte realisieren.

Der Offsetspannungskompensationsvorgang erstreckt sich über eine bestimmte Zeitdauer, beispielsweise 50 µs bei einem Empfänger im GSM-System mit seinen üblichen TDMA-Zeitrahmen. In dieser kurzen Zeitdauer muß der Offset abgeglichen worden sein. Die Zeitdauer, bis ein vorhandener Offset abgeglichen ist, ist von der Größe der Offsetspannung, der Größe der Kapazität des externen Kondensators und von der Größe des Ladestromes des Abtast(Sample)-Operationsverstärkers abhängig.

Die Größe der Kapazität des externen Kondensators und des Ladestromes müssen so eingestellt werden, daß eine typische Offsetspannung in dem kurzen Zeitraum von z.B. 50 µs gerade ausgeregelt werden kann. Durch Verringerung der Größe der Kapazität des externen Kondensators und durch Erhöhung des Ladestromes könnte der Ausregel- bzw. Kompensationsvorgang verkürzt werden. Dies kann aber dazu führen, daß die Regelung instabil wird und Schwingungen entstehen.

Es kommt auch vor, daß der externe Kompensationskondensator entladen ist, so daß dann sehr große Offsetspannungen auftreten. Dies ist insbesondere der Fall, wenn der Funkempfänger zum ersten Mal eingeschaltet wird, längere Zeit ausgeschaltet war oder wenn sich der Kondensator aus irgend einem anderen Grund entladen hat. In diesem Fall reicht die kurze, zur Verfugung stehende Zeitdauer von z.B. 50 µs zur Kompensation des störenden Offsets nicht aus, da der Kondensator erheblich mehr aufgeladen werden müßte, als es in dieser kurzen Zeitdauer möglich ist.

Eine Beschleunigung der Aufladung durch eine entsprechende Dimensionierung der Abtast- und Halteschaltung (Sample and Hold) ist wegen der vorstehend erwähnten Gründe (Instabilität, Schwingneigung) nicht möglich.

Bisher wurde daher der Offsetkompensationsvorgang verlängert. Dafür ist von seiten des Basisband-Prozessors zusätzlicher Rechenaufwand erforderlich. Außerdem ist aufgrund der längeren Dauer der Kompensation, z.B. etwa 200 µs statt 50 µs, der anschließende Empfangszeitschlitz nicht mehr nutzbar.

Wenn das OCE-Steuersignal nicht vom Basisband-Prozessor, sondern im Empfängerschaltungsbaustein selbst erzeugt wird, dann ist die Dauer des jeweiligen Offsetkompensationsvorgangs auf eine feste Dauer von z.B. 50 µs festgelegt. In diesem Fall wären daher mehrere Kompensationszyklen notwendig, um einen größeren Offset zu kompensieren.

Der Erfindung liegt die Aufgabe zugrunde, ein Verfahren und eine Schaltung zur Durchführung des Verfahrens anzugeben, die es möglich machen, im Basisband die Offsetspannungskompensation in jedem Fall, also auch bei Vorliegen größerer Offsetspannungen, während einer festen, definierten Kompensationsdauer von z.B. 50 µs im Funkempfänger- oder -transceiverchips durchzuführen, ohne daß zusätzliche Rechnerleistung im Basisband-Prozessor erforderlich wird und ohne daß sich eine störende Instabilität oder Schwingneigung der Abtast- und Halteschaltung einstellt.

Diese Aufgabe wird bei einem gattungsgemäßen Verfahren durch die im kennzeichnenden. Teil des Patentanspruchs 1 angegebenen Merkmale gelöst.

Nach der Erfindung wird somit der Ladezustand des extern angebrachten Kompensationskondensators chipintern ausgewertet. Ist der Kondensator entladen oder befindet sich der augenblickliche Ladezustand weit unter dem typischen Ladezustand, dann wird aufgrund des bei der Ladezustandsauswertung anfallenden Ergebnisses der Ladestrom im Abtast(Sample)-Operationsverstärker erhöht. Gemäß einer vorteilhaften Weiterbildung der Erfindung wird eine solche Erhöhung des Ladestromes im Abtast-Operationsverstärker durch Einschalten einer Zusatzstromquelle vorgenommen. Mit Hilfe des erhöhten Ladestromes wird der Kondensator nun wesentlich schneller aufgeladen. Kommt der Ladezustand des Kondensators schließlich in die Größenordnung des typischen Ladezustandes, so wird die erhöhte Ladestromerzeugung im Abtast-Operationsverstärker wieder zurückgeschaltet. Dies hat zur Folge, daß die restliche Kompensation des nun geringeren Offsets mit der normalen Geschwindigkeit weiterläuft. Das rechtzeitige Zurückschalten des erhöhten Ladestromes erfolgt deswegen, damit die Abtast-und Halteschaltung nicht instabil wird und auch nicht zu schwingen beginnt.

Das Verfahren nach der Erfindung zur Beschleunigung der Offsetspannungskompensation in Abhängigkeit vom Ladezustand der Kompensationskondensatoren erlaubt es, das Prinzip der Offsetspannungskompensation mittels einer Abtast- und Halteschaltung auch in solchen Receiver- und Transceiverschaltungen einzusetzen, bei denen eine starre Dauer von beispielsweise 50 µs für den Offsetkompensationsvorgang festgelegt ist. Es ist durch das Verfahren nach der Erfindung möglich, beliebige auftretende Offsetspannungen in der vorgegebenen Zeit zu kompensieren, ohne daß die Regelung in einen instabilen Zustand gerät oder zu schwingen beginnt.

Die Erfindung ist also in wesentlichen darin zu sehen, den Ladezustand des Kompensationskondensators chipintern auszuwerten. Das Ergebnis dieser Auswertung wird dann dazu benutzt, den Ladestrom des Abtast-Operationsverstärkers an den jeweiligen Ladezustand des Kompensationskondensators anzupassen. Damit wird eine minimale Offsetkompensationszeit bei stabil bleibender Regelung erreicht.

Eine die vorher angegebene Aufgabe lösende Schaltung zur Durchführung des Verfahrens nach Anspruch 1 und 2 ist dadurch gekennzeichnet, daß auf dem integrierten Schaltungsbaustein eine Ladestrom-Auswerteschaltung vorgesehen ist, deren einer Eingang mit der bausteininternen Zuführung zum extern angebrachten Kondensator verbunden ist, daß die Auswerteschaltung einen Differenzverstärker aufweist, der den Ladezustand des Kondensators mit dem Referenzladewert vergleicht, und daß im Abtast(Sample)-Operationsverstärker eine Zusatzstromquelle vorgesehen ist, die über eine Steuersignalleitung mit dem Ausgang der Auswerteschaltung verbunden ist und über diese aktiviert wird, wenn der im Differenzverstärker festgestellte Differenzwert aus dem Ladezustandswert des Kondensators und dem Referenzladewert einen festgelegten Wert überschreitet, und wieder deaktiviert wird, wenn dieser Differenzwert einen anderen festgelegten Wert wieder unterschreitet.

Das Verfahren und die vorstehend angegebene Schaltung zur Durchführung dieses Verfahrens lassen sich besonders vorteilhaft in einem kleinen transportablen Mobilfunkgerät (Handy) verwenden, das in einem mit Zeitmultiplex (TDMA) arbeitenden Mobilfunksystem, beispielsweise in einem GSM- oder PCN/PCS-Mobilfunksystem, eingesetzt wird.

Die Erfindung wird im folgenden anhand von Zeichnungen erlautert. Es zeigen:
- FIG. 1: das bereits vorher beschriebene Blockschaltbild einer integrierten Schaltung mit einer Abtast- und Halteschaltung zur Erlauterung des Prinzips der Offsetspannungskompensation,
- FIG. 2: das Blockschaltbild einer entsprechend der Erfindung ausgebildeten integrierten Schaltung ebenfalls mit einer Abtast- und Halteschaltung, jedoch mit einer Auswerteschaltung zur Beschleunigung des Offsetkompensationsvorgangs in Abhängigkeit vom Ladezustand des Kompensationskondensators,
- FIG. 3: ein Diagramm zur vergleichenden Veranschaulichung des zeitlichen Verlaufs der Offsetspannung während des Kompensationsvorganges, und
- FIG. 4: ein Blockschaltbild eines integrierten TransceiverBausteins zur Anwendung des Verfahrens nach der Erfindung.

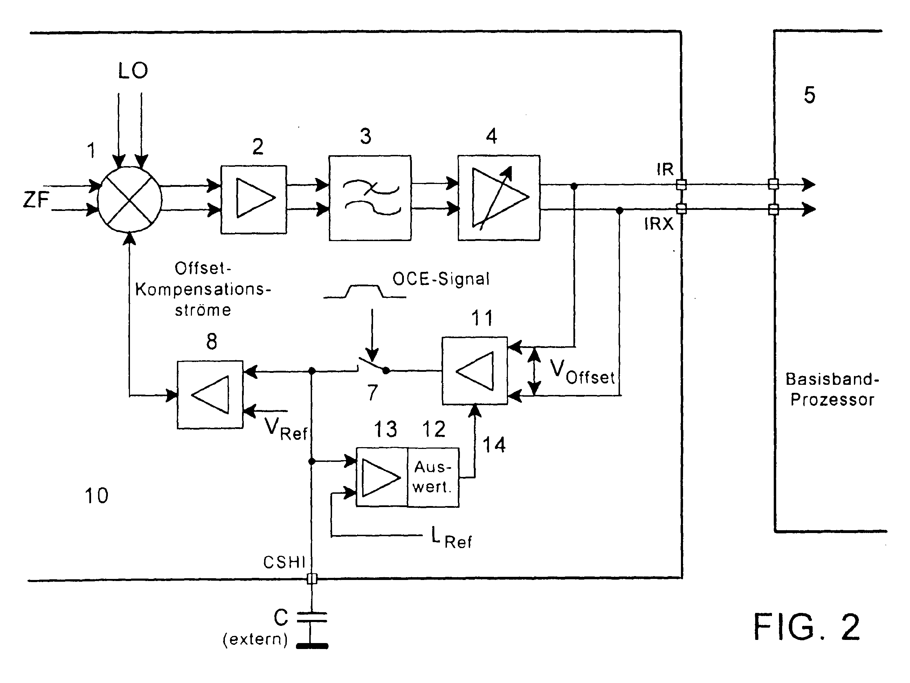

Die in FIG. 2 dargestellte, das Verfahren nach der Erfindung durchführende Schaltung in einem integrierten Receiver- oder Transceiver-Schaltungsbaustein 10 entspricht in weiten Teilen der Schaltung nach FIG. 1, weswegen in beiden Figuren für entsprechende Elemente auch übereinstimmende Bezugszeichen verwendet werden.

Die im Basisband am Ausgang vorhandenen Offsetspannungen V_{Offset} werden ebenfalls mit Hilfe einer Abtast- und Halteschaltung kompensiert. Wie in FIG. 2 im einzelnen gezeigt ist, wird dazu das differentielle Basisbandsignal, das mit Hilfe eines mit einer Lokaloszillatorfrequenz LO gespeisten Demodulators 1 aus dem ZF-Signal ZF gewonnen und nach einem Pufferverstärker 2 mittels eines Tiefpaßfilters 3 gefiltert wird, intern nach Durchlaufen eines Basisband-Regelverstärkers 4 am Basisbandausgang IR, IRX, der mit einem nachfolgenden Basisband-Prozessor 5 verbunden ist, abgegriffen und einem steuerbar ausgebildeten Abtast(Sample)-Operationsverstärker 11 zugeführt. Dieser Operationsverstärker 11 lädt bzw. entlädt je nach Polarität der Offsetspannung V_{Offset} über einen gesteuerten Abtastschalter 7 der Abtast- und Halteschaltung und über einen Ausgang CSHI einen extern angebrachten Kondensator C, der das Halteglied der Abrast- und Halteschaltung bildet.

Die Kondensatorspannung wird einem Differenzverstärker 8 zugeführt und dort mit einer Referenzspannung V_{Ref} verglichen. Am Ausgang des Differenzverstärkers 8 werden Kompensationsströme erzeugt, die der Offsetspannung V_{Offset} entgegenwirken. Der Vorgang der Offsetspannungskompensation wird vor jedem TDMA-Empfangszeitschlitz mit Hilfe des dem Steuereingang des Abtastschalters 7 zugeleiteten impulsförmigen Steuersignals OCE mit konstanter Impulsbreite von z.B. 50 µs durchgeführt.

Der Ladezustand des extern angebrachten Kondensators C wird an einem einer Ladestrom-Auswerteschaltung 12 vorgeschalteten Differenzverstärker 13 erfaßt und mit einem Referenzladezustandswert L_{Ref} verglichen. Mittels eines über eine Steuersignalleitung 14 geführten Steuersignals wird eine Zusatzstromquelle im Abtast(Sample)-Operationsverstärker 11 ein- oder ausgeschaltet.

Ist der Kondensator C ganz entladen oder weit unter dem Referenzladezustandswert L_{Ref}, dann wird die Zusatzstromquelle im Abtast-Operationsverstärker 11 aktiviert. Kommt der Ladezustand des Kondensators C in die Größenordnung des Referenzladezustands L_{Ref}, so wird die Zusatzstromquelle im Abtast-Operationsverstärker 11 aus Stabilitätsgründen wieder abgeschaltet, d.h. die restliche Offsetspannungskompensation läuft nicht mehr mit erhöhtem Ladestrom, sondern mit dem Standardladestrom, also mit der normalen Geschwindigkeit ab.

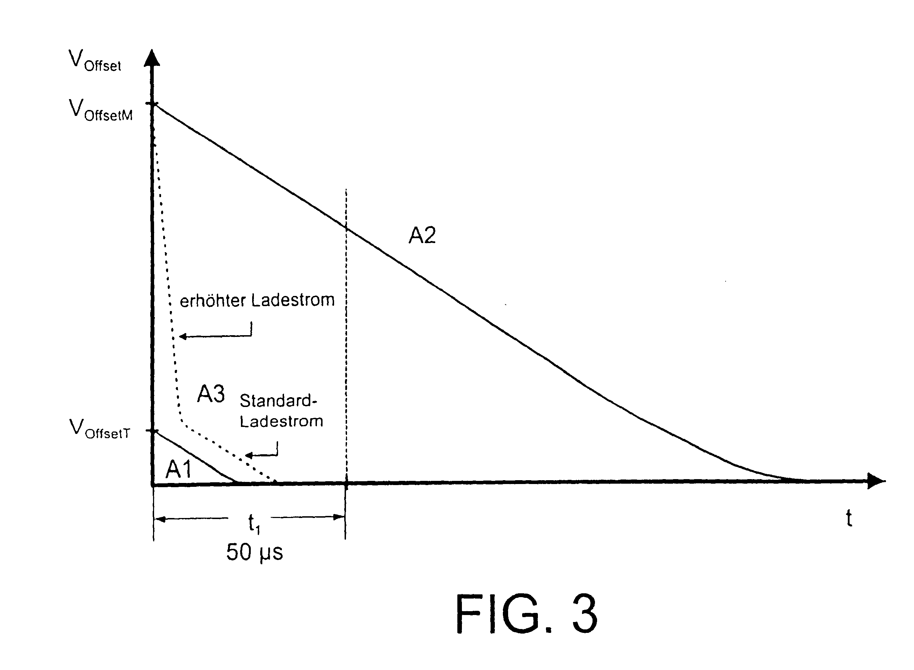

In dem in FIG. 3 dargestellten Ablaufdiagramm ist der von der Zeit t abhängige Verlauf der Offsetspannung V_{Offset} während des Kompensationsvorgangs für verschiedene Fälle veranschaulicht. Die beiden Fälle A1 und A2, die mit jeweils durchgezogener Funktionslinie gezeichnet sind, stellen Kompensationsverläufe mit jeweils konstantem Ladestrom im Abtast(Sample)-Operationsverstarker dar. Dabei ist im Fall Al eine typische Offsetspannung V_{OffsetT} zu kompensieren, was mit dem konstanten Standardladestrom, also ohne zugeschaltete Zusatzstromquelle im Abtast-Operationsverstärker, bis zum Ablauf der festgelegten konstanten Kompensationszeit t1 von z.B. 50 µs sicher erreicht wird.

Im Fall A2 ist dagegen eine maximale Offsetspannung V_{OffsetM} bei entladenem Kompensationskondensator zu kompensieren, was in der vorgegebenen Zeit t1 von 50 µs bei weitem nicht vollständig zu erreichen ist. Im Fall A2 reichen also die 50 µs zur Kompensation des Offsets nicht aus, da der Kondensator wesentlich mehr aufgeladen werden muß. Eine Verlängerung der Kompensationsvorgangsdauer z.B. bis zu 200 µs ist aber wegen des hohen zusätzlichen Rechenaufwandes im Basisband-Prozessor und der Nichtnutzbarkeit des anschließenden TDMA-Empfangszeitschlitzes von Nachteil.

Die gepunktet dargestellte Linie A3 in FIG. 3 zeigt den Verlauf der Offsetspannung während des unter Anwendung des Verfahrens nach der Erfindung ablaufenden Kompensationsvorgangs. Hierbei wird wie im Fall A2 von einer maximalen Offsetspannung V_{ofrsetM} bei vollständig entladenem Kompensationskondensator ausgegangen.

Bei der Auswertung des Ladezustands wird zu Beginn festgestellt, daß der Kondensator entladen ist, und infolgedessen wird die Zusatzstromquelle im steuerbar ausgebildeten Abtast-Operationsverstärker eingeschaltet, wodurch der Ladestrom erhöht und eine schnellere Offsetkompensation erzielt wird.

Dieser erste Anteil des Offsetkompensationsvorgangs wird durch den steileren Teil der gepunktet dargestellten Linie A3 in FIG. 3 angezeigt. Kommt der Ladezustand des Kompensationskondensators schließlich in die Größenordnung des typischen Ladezustands, d.h. in den Bereich der typischen Offsetspannung V_{offsetT,} so wird aufgrund der Auswertung die Zusatzstromquelle im Abtast-Operationsverstärker wieder abgeschaltet.

Dies hat zur Folge, daß die restliche Kompensation der jetzt geringeren Offsetspannung mit dem Standardladestrom und damit in der normalen Geschwindigkeit abläuft. Dieser zweite Anteil des Offsetkompensationsvorganges wird durch den flacheren Teil der gestrichelt dargestellten Linie A3 angezeigt.

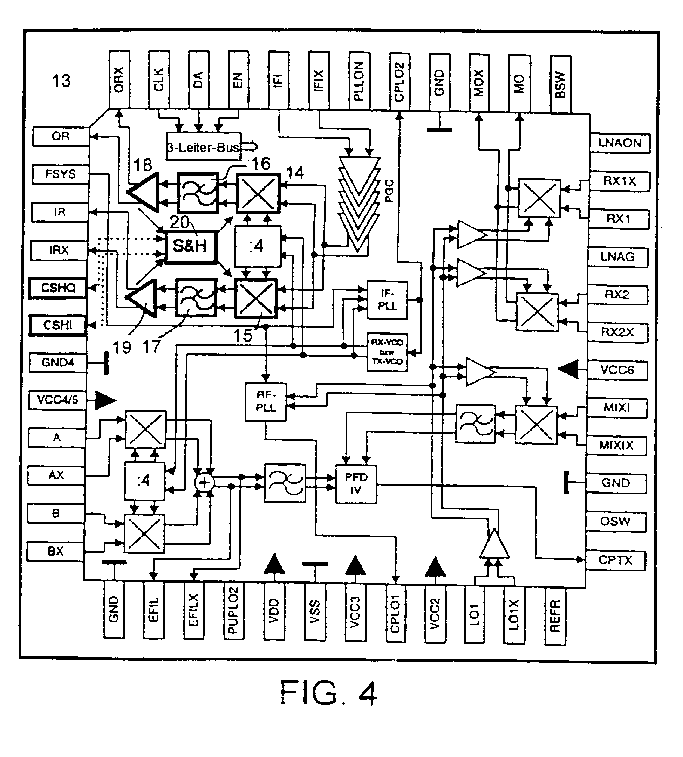

In FIG. 4 ist ein Blockschaltbild einer gesamten, in einem Schaltungsbaustein 15 integrierten Transceiverschaltung dargestellt. Die von der Erfindung betroffenen Elemente im aus zwei differentiellen Signalpfaden (I- und Q-Pfad) bestehenden Empfangspfadteil wie die beiden Demodulatoren 16 und 17, die beiden Tiefpaßfilter 18 und 19, die beiden differentiellen Basisband-Regelverstärker 20 und 21 sowie die Abtast- und Halteschaltung (Sample- and Hold-Schaltung; S&H) 22, die über die Pins CSHI und CSHQ mit externen, in der FIG. 4 nicht dargestellten, der Offsetkompensation dienenden Kondensatoren zusammenarbeitet, sind mit fett gezeichneten Umrandungslinien dargestellt.

Die Abtast- und Halteschaltung 22 enthält die Auswerteschaltung zur Ermittlung des Kondensator-Ladestromes und den mit der zuschaltbaren Zusatzstromquelle versehenen Abtast-Operationsverstärker, der das diesbezügliche Steuersignal von der Auswerteschaltung erhält. Aus FIG. 4 ist ersichtlich, daß der integrierte Transceiver-Schaltungsbaustein 15 keinen eigenen Pin für eine externe Zuführung des OCE-Steuersignals an die Abtast- und Halteschaltung 22 aufweist, da dieses Steuersignal bausteinintern als impulsförmiges Signal mit vorgegebener konstanter Impulsbreite erzeugt wird.

## Patentansprüche

1. Verfahren zur Kompensationssteuerung von Offsetspannungen im Basisband einer in einem Schaltungsbaustein integrierten, im Zeitmultiplexverfahren mit Empfangszeitschlitzen arbeitenden Funkempfangsschaltung unter Verwendung eines das Basisbandausgangssignal abgreifenden Abtast-Operationsverstärkers, der über einen von einem Offset-Compensation Enable-Steuersignal vor jedem Empfangszeitschlitz zur Durchführung eines Offset-Kompensationsvorgangs für eine definierte Zeitdauer durchgeschalteten Abtastschalter einer Abtast- und Halteschaltung je nach Polarität der Offsetspannung einen extern angebrachten Kondensator lädt bzw. entlädt, dessen jeweils anliegende Spannung bausteinintern mittels eines Differenzverstärkers mit einer Referenzspannung verglichen wird und für die Erzeugung eines der Offsetspannung entgegenwirkenden Kompensationsstromes sorgt, **dadurch gekennzeichnet, daß** bausteinintern der Ladezustand des Kondensators (C) ermittelt und derart ausgewertet wird, daß bei entladenem oder weit unter dem typischen Ladezustand liegenden Kondensator der Ladestrom für den Kondensator im steuerbar ausgebildeten Abtast-Operationsverstärker (11) erhöht wird, und daß der erhöhte Ladestrom wieder zurückgeschaltet wird, wenn der Ladezustand des Kondensators in die Größenordnung des typischen Ladezustands kommt.

2. Verfahren nach Anspruch 1, **dadurch gekennzeichnet, daß** die Erhöhung des Ladestromes im steuerbar ausgebildeten Abtast -Operationsverstärker (11) durch Einschalten einer Zusatzstromquelle vorgenommen wird.

3. Schaltung zur Durchführung des Verfahrens nach Anspruch 1 und 2, **dadurch gekennzeichnet, daß** auf dem integrierten Schaltungsbaustein (10) eine Ladestrom-Auswerteschaltung (12) vorgesehen ist, deren einer Eingang mit der bausteininternen Zuführung zum extern angebrachten Kondensator (C) verbunden, ist, daß die Auswerteschaltung einen Differenzverstärker (13) aufweist, der den Ladezustand des Kondensators mit einem Referenzladewert (L_{Ref}) vergleicht, und daß im steuerbar ausgebildeten Abtast-Operationsverstärker (11) eine Zusatzstromquelle vorgesehen ist, die über eine Steuersignalleitung (14) mit dem Ausgang der Auswerteschaltung (12) verbunden ist und über diese aktiviert wird, wenn der im Differenzverstärker festgestellte Differenzwert aus dem Ladezustandswert des Kondensators (C) und dem Referenzladewert (L_{Ref}) einen festgelegten Wert überschreitet, und wieder deaktiviert wird, wenn dieser Differenzwert einen anderen festgelegten Wert wieder unterschreitet.

4. Verwendung des Verfahrens nach einem der Ansprüche 1 und 2 sowie der Schaltung nach Anspruch 3 in einem transportablen Mobilfunkgerät, das in einem mit Zeitmultiplex arbeitenden Mobilfunksystem, beispielsweise in einem GSM- oder PCN/PCS-Mobilfunksystem, eingesetzt wird.

## Claims

1. Method for compensation control of offset voltages in baseband for a radio receiving circuit, which is integrated in a circuit module and operates using the time-division multiplexing method with reception time slots, using a sampling operational amplifier which taps off the baseband output signal and charges and discharges an externally connected capacitor, depending on the polarity of the offset voltage via a sampling switch, which is switched on for a defined time period by an offset compensation enable control signal before each reception time slot, in order to carry out an offset compensation process, in a sample and hold circuit, with the voltage which is in each case present on the capacitor being compared within the module by means of a differential amplifier with a reference voltage and ensuring the production of a compensation current opposing the offset voltage, **characterized in that** the state of charge of the capacitor (C) is determined and is evaluated within the module such that, when the capacitor is discharged or is well below the typical stage of charge, the charging current for the capacitor is increased in the controllable sampling operational amplifier (11) and such that the increased charging current is reduced again when the state of charge of the capacitor is in the order of magnitude of the typical state of charge.

2. Method according to Claim 1, **characterized in that** the charging current is increased in the controllable sampling operational amplifier (11) by switching on an additional current source.

3. Circuit for carrying out the method according to Claims 1 and 2, **characterized in that** a charging current evaluation circuit (12) is provided on the integrated circuit module (10), one of whose inputs is connected to the module-internal supply to the externally connected capacitor (C), **in that** the evaluation circuit has a differential amplifier (13) which compares the state of charge of the capacitor with a reference charge value (L_{Ref}), and **in that** an additional current source is provided in the controllable sampling operational amplifier (11), is connected via a control signal line (14) to the output of the evaluation circuit (12) and is activated via this when the difference value found in the differential amplifier from the state of charge value of the capacitor (C) and reference charge (L_{Ref}) exceeds a defined value, and deactivated again when this difference value falls below another defined value again.

4. Use of the method according to one of Claims 1 and 2 and of the circuit according to Claim 3 in a transportable mobile radio which is used in a mobile radio system which operates using time-division multiplexing, for example in a GSM or PCN/PCS mobile radio system.

## Revendications

1. Procédé pour le contrôle de la compensation de tensions offset dans la bande de base d'un circuit de réception radio, intégré dans un bloc de circuit et fonctionnant en accès par partage du temps avec des intervalles temporels de réception, utilisant un amplificateur opérationnel de balayage prélevant le signal de sortie de la bande de base et qui charge ou décharge un condensateur raccordé de façon externe, en fonction de la polarité de la tension offset, ceci via un commutateur de balayage d'un circuit échantillonneur-bloqueur, commuté par un signal de commande offset-compensation enable avant chaque intervalle de temps de réception afin de réaliser un processus de compensation offset pour une durée définie,
la tension du condensateur appliquée à chaque fois, est comparée à l'intérieur du bloc fonctionnel à l'aide d'un amplificateur différenciateur avec une tension de référence et le condensateur sert à produire un courant de compensation opposé à la tension offset,
**caractérisé en ce qu'**
à l'intérieur du bloc fonctionnel, l'état de charge du condensateur (C) est déterminé et exploité de telle façon que le courant de charge du condensateur dans l'amplificateur opérationnel de balayage (11), réalisé de façon réglable, est augmenté quand le condensateur est déchargé ou en dessous de l'état de charge typique et que le courant de charge augmenté est, à nouveau, diminué lorsque l'état de charge du condensateur arrive dans l'ordre de grandeur de l'état de charge typique.

2. Procédé selon la revendication 1 **caractérisé en ce que** l'augmentation du courant de charge dans l'amplificateur opérationnel de balayage (11) réglable est réalisée par connexion d'une source de courant supplémentaire.

3. Circuit pour la réalisation du procédé selon la revendication 1 et 2 **caractérisé en ce qu'**un circuit d'évaluation de courant de charge (12) est prévu sur le bloc de circuit intégré (10), une entrée du circuit d'évaluation étant reliée avec l'alimentation du bloc qui raccorde le condensateur (C) externe,
que le circuit d'évaluation comprend un amplificateur différenciateur (13) qui compare l'état de charge du condensateur avec une valeur de charge de référence (L_{ref}), et qu'une source de courant supplémentaire est prévue dans l'amplificateur opérationnel de balayage (11), réalisé de façon réglable, la source de courant supplémentaire étant reliée, via une ligne de signal de commande (14), avec la sortie du circuit d'évaluation (12) et est activée via celle-ci lorsque la différence de valeurs déterminée dans l'amplificateur différentiel à partir de la valeur d'état de charge du condensateur (C) et la valeur de charge de référence (L_{Ref}) dépasse une valeur donnée et est, à nouveau, désactivée lorsque cette différence passe, de nouveau, en dessous d'une autre valeur donnée.

4. Utilisation du procédé selon une des revendications 1 et 2 ainsi que du circuit selon la revendication 3 dans un téléphone portable utilisé dans un système de téléphonie mobile fonctionnant en accès par partage du temps comme par exemple un GSM ou système de téléphonie mobile PCN/PCS.
